# EUROPEAN PATENT APPLICATION

(11) **EP 4 454 812 A1**
(43) Date of publication of application: **30.10.2024**
(21) Application number: 22910568.9
(22) Date of filing: 25.10.2022
(51) Int. Cl.: B24B 41/06, B24B 7/04, B24B 49/10, H01L 21/304

(54) **SUBSTRATE PROCESSING METHOD AND SUBSTRATE PROCESSING DEVICE**

(30) Priority: 24.12.2021 JP 2021211169
(71) Applicant: EBARA CORPORATION, Ota-ku, Tokyo 144-8510 (JP)
(72) Inventor: KASHIWAGI, Makoto, Tokyo 144-8510 (JP)
(74) Representative: Carstens, Dirk Wilhelm
(86) International application number: PCT/JP2022/039674
(87) International publication number: WO 2023/119847

(57) **Abstract**

The present invention relates to a substrate processing method and a substrate processing apparatus for processing a substrate, such as a wafer. In the substrate processing method, rollers (11a, 11b) secured to eccentric shafts (13a, 13b) including a reference shaft (13a) and a movable shaft (13b) are brought into contact with the periphery of a substrate (W) having a notch (Nw), and further the rollers (11a, 11b) are moved in a circular motion, thereby rotating and circularly moving the substrate (W), and further, processing the substrate (W) by bringing a processing tool (201) into contact with the substrate (W). During processing of the substrate (W), a rotational speed of the substrate (W) is calculated based on measured values of a notch detection sensor (77) which is capable of detecting that the notch (Nw) has passed the movable shaft (13b), and an alarm is issued when the rotational speed of the substrate (W) is out of an allowable range which is set with respect to a theoretical rotational speed of the substrate (W).

## Description

### Technical Field

The present invention relates to a substrate processing method and a substrate processing apparatus for processing a substrate, such as a wafer.

### Background Art

Devices, such as memory circuits, logic circuits, and image sensors (e.g., CMOS sensors), are becoming more highly integrated these days. In a process for forming such a device, foreign matters (e.g., fine particles and dust) may adhere to the device. Foreign matters adhering to a device can cause a short-circuit between interconnects or a circuit defect. Therefore, in order to enhance reliability of devices, it is necessary to clean a substrate (e.g., wafer), on which devices are formed, by bringing a processing tool (e.g., cleaning tool) into contact with the substrate to thereby remove foreign matter on the substrate.

The above-described foreign matters, such as fine particles and dust, may adhere also to a back surface (bare-silicon surface) of the substrate. If such foreign matters adhere to the back surface of the substrate, the substrate may separate from a stage reference surface, or a front surface of the substrate may be inclined with respect to the stage reference surface in an exposure apparatus, resulting in patterning shift or deviation of focal distance. To prevent such problems, it is necessary to remove the foreign matters by bringing a processing tool (e.g., polishing tool) into contact with the back surface of the substrate to thereby remove foreign matter on the substrate.

There has recently been an increasing demand for an apparatus which can more efficiently process an entirety of a substrate surface. Therefore, a substrate holding apparatus has been proposed in which a periphery of a substrate is held by rollers coupled to eccentric shafts, and the substrate is rotated about its own axis while the substrate is made a circular motion by rotating the eccentric shafts about their axes, with positions of the eccentric shafts themselves remain stationary (for example, see Japanese Laid-Open Patent Publication No. 2019-83224). In a substrate processing apparatus using such a substrate holding apparatus, a processing tool can process the entirety of the surface, including its outermost area, of the substrate while preventing the rollers from coming into contact with the processing tool. The combination of the circular motion of the substrate and the rotation of the substrate about its axis can increase speed of the substrate at any point on the surface of the substrate. As a result, an efficiency of processing of the substrate can be improved.

### Citation List

### Patent Literature

Patent document 1: Japanese laid-open patent publication No. 2021-2639

### Summary of Invention

### Technical Problem

When the substrate is rotated around its own axis by the rollers coupled to the eccentric shafts while the substrate is made a circular motion, it is possible to indirectly determine a rotational speed of the substrate based on a ratio of a diameter of the substrate to a diameter of the roller and a rotational speed of the rollers. On the other hand, it is difficult to directly measure the rotational speed of the substrate. Accordingly, in a conventional substrate processing apparatus, the theoretical rotation speed of the substrate is matched to the set rotation speed by controlling the rotation speed of the rollers.

However, an actual rotational speed of the substrate may deviate from the theoretical rotational speed. Examples of causes of deviation of the actual rotation speed from the theoretical rotation speed include: (1) manufacturing and/or processing errors between each roller (e.g., errors in the diameter of the substrate contact surface between each roller), (2) errors in the diameter between each substrate (or the circumference between each substrate), (3) slipping of the substrate on the substrate contact surface of the roller caused due to a decrease in gripping force of the roller on the substrate, (4) slipping of the substrate on the substrate contact surface of the roller caused due to a magnitude of frictional force between the processing tool and the surface of the substrate, and (5) wear in the substrate contact surface of the roller (i.e., change in a diameter of the roller).

When the actual rotational speed of the substrate deviates from the theoretical rotational speed, there may occur in an adverse effect on processing performance of the substrate (e.g., cleaning performance or polishing performance). For example, in a substrate processing apparatus in which a polishing tool is brought into contact with a back surface of the substrate to thereby slightly polish the back surface of the substrate together with foreign matters, a decrease in the rotational speed of the substrate relative to the rotational speed of the circular motion of the substrate is predicted to result in a decrease in the polishing rate of the substrate.

It is therefore an object of the present invention to provide a substrate processing method and a substrate processing apparatus capable of monitoring whether or not a substrate is properly held by rollers.

### Solution to Problem

In one embodiment, there is provided a substrate processing method, comprising: contacting a periphery of a substrate having a notch with three or more rollers each secured to three or more eccentric shafts including at least one reference shaft and at least one movable shaft which can be moved in a direction closer to and away from the reference shaft, each of the eccentric shafts having a first shaft portion coupled to electric motor, and a second shaft portion which is eccentric from the first shaft portion and to which the rollers are secured; rotating the first shaft portions of the three or more eccentric shafts about their respective own axes, and further causes the three or more rollers to make a circular motion, thereby rotating the substrate about its axis and causing the substrate to make a circular motion; contacting a processing tool with the rotating and circularly moving substrate to thereby process the substrate; calculating a rotational speed of the substrate, during processing of the substrate, based on measured values of a notch detection sensor for detecting that a notch has passed through the movable shaft; and issuing an alarm when the calculated rotational speed of the substrate is out of an allowable range which is set with respect to a theoretical rotational speed of the substrate.

In one embodiment, the substrate processing method further comprises: performing an additional processing to the substrate based on a difference or a ratio between the rotational speed of the substrate and the theoretical rotational speed when the calculated rotational speed of the substrate falls below a lower limit of the allowable range.

In one embodiment, the notch detection sensor is an acceleration sensor configured to measure acceleration generated when the movable shaft moves closer to and away from the reference shaft.

In one embodiment, the notch detection sensor is a distance sensor configured to measure a movement distance of the movable shaft when the movable shaft moves closer to and away from the reference shaft.

In one embodiment, there is provided a substrate processing method, comprising: contacting a periphery of a substrate having a notch with three or more rollers each secured to three or more eccentric shafts including at least one reference shaft and at least one movable shaft which can be moved in a direction closer to and away from the reference shaft, each of the eccentric shafts having a first shaft portion coupled to electric motors, and a second shaft portion which is eccentric from the first shaft portion and to which the rollers are secured; rotating the first shaft portions of the three or more eccentric shafts about their respective own axes, and further causes the three or more rollers to make a circular motion, thereby rotating the substrate about its axis and causing the substrate to make a circular motion; contacting a processing tool with the rotating and circularly moving substrate to thereby process the substrate; measuring, during processing of the substrate, a movement distance of the movable shaft by use of a distance sensor, and further detecting that a notch has passed through the movable shaft, by use of a notch detection sensor; issuing an alarm when measured value of the distance sensor is out of a predetermined allowable range, and the notch detection sensor is not detecting the notch; and not issuing an alarm when the measured value of the distance sensor is out of the predetermined allowable range, and the notch detection sensor is detecting the notch.

In one embodiment, during a predetermined rotation angle of the roller before and after a time point of detection of the notch by the notch detection sensor, the alarm is canceled even if the measured value of the distance sensor is out of the predetermined allowable range.

In one embodiment, there is provided a substrate processing method, comprising: contacting a periphery of a substrate having a notch with three or more rollers each secured to three or more eccentric shafts including at least one reference shaft and at least one movable shaft which can be moved in a direction closer to and away from the reference shaft, each of the eccentric shafts having a first shaft portion coupled to electric motors, and a second shaft portion which is eccentric from the first shaft portion and to which the rollers are secured; rotating the first shaft portions of the three or more eccentric shafts about their respective own axes, and further causes the three or more rollers to make a circular motion, thereby rotating the substrate about its axis and causing the substrate to make a circular motion; contacting a processing tool with the rotating and circularly moving substrate to thereby process the substrate; measuring, during processing of the substrate, a movement distance of the movable shaft by use of a distance sensor, and further detecting that a notch has passed through the movable shaft, by use of the distance sensor; issuing an alarm when measured value of the distance sensor is out of a predetermined allowable range, and the distance sensor is not detecting the notch; and not issuing an alarm when the measured value of the distance sensor is out of the predetermined allowable range, and the distance sensor is detecting the notch.

In one embodiment, during a predetermined rotation angle of the roller before and after a time point of detection of the notch by the distance sensor, the alarm is canceled even if the measured value of the distance sensor is out of the predetermined allowable range.

In one embodiment, there is provided a substrate processing apparatus, comprising: three or more eccentric shafts including at least one reference shaft and at least one movable shaft, each of the eccentric shafts having a first shaft portion, and a second shaft portion which is eccentric from the first shaft portion; three or more rollers each secured to the second shaft portion of each of the three or more eccentric shafts, and capable of contacting a periphery of a substrate having a notch; three or more electric motors for rotating the first shaft portions of the three or more eccentric shafts about their respective own axes, and further causes the three or more rollers to make a circular motion, thereby rotating the substrate about its axis and causing the substrate to make a circular motion; an actuator configured to move the at least one movable shaft in a direction closer to and away from the reference shaft; a processing tool configured to contact a surface of the rotating and circularly moving substrate to thereby process the surface of the substrate; a notch detection sensor configured to detect that the notch has passed through the movable shaft; and a controller to which the notch detection sensor is coupled, wherein the controller is configured: to calculate a rotational speed of the substrate, during processing of the substrate, based on measured values of the notch detection sensor; and to issue an alarm when the calculated rotational speed of the substrate is out of an allowable range which is set with respect to a theoretical rotational speed of the substrate.

In one embodiment, the controller is configured to perform an additional processing to the substrate based on a difference or a ratio between the rotational speed of the substrate and the theoretical rotational speed when the calculated rotational speed of the substrate falls below a lower limit of the allowable range.

In one embodiment, the notch detection sensor is an acceleration sensor configured to measure acceleration generated when the movable shaft moves closer to and away from the reference shaft.

In one embodiment, the notch detection sensor is a distance sensor configured to measure a movement distance of the movable shaft when the movable shaft moves closer to and away from the reference shaft.

In one embodiment, there is provided a substrate processing apparatus, comprising: three or more eccentric shafts including at least one reference shaft and at least one movable shaft, each of the eccentric shafts having a first shaft portion, and a second shaft portion which is eccentric from the first shaft portion; three or more rollers each secured to the second shaft portion of each of the three or more eccentric shafts, and capable of contacting a periphery of a substrate having a notch; three or more electric motors for rotating the first shaft portions of the three or more eccentric shafts about their respective own axes, and further causes the three or more rollers to make a circular motion, thereby rotating the substrate about its axis and causing the substrate to make a circular motion; an actuator configured to move the at least one movable shaft in a direction closer to and away from the reference shaft; a processing tool configured to contact a surface of the rotating and circularly moving substrate to thereby process the surface of the substrate; a notch detection sensor configured to detect that the notch has passed through the movable shaft; a distance sensor configured to measure a movement distance of the movable shaft when the movable shaft moves closer to and away from the reference shaft; and a controller to which the notch detection sensor and the distance sensor is coupled, wherein the controller is configured: to issue an alarm when measured value of the distance sensor is out of a predetermined allowable range, and the notch detection sensor is not detecting the notch; and not to issue an alarm when the measured value of the distance sensor is out of the predetermined allowable range, and the notch detection sensor is detecting the notch.

In one embodiment, the controller is configured to cancel the alarm, during a predetermined rotation angle of the roller before and after a time point of detection of the notch by the notch detection sensor, even if the measured value of the distance sensor is out of the predetermined allowable range.

In one embodiment, there is provided a substrate processing apparatus, comprising: three or more eccentric shafts including at least one reference shaft and at least one movable shaft, each of the eccentric shafts having a first shaft portion, and a second shaft portion which is eccentric from the first shaft portion; three or more rollers each secured to the second shaft portion of each of the three or more eccentric shafts, and capable of contacting a periphery of a substrate having a notch; three or more electric motors for rotating the first shaft portions of the three or more eccentric shafts about their respective own axes, and further causes the three or more rollers to make a circular motion, thereby rotating the substrate about its axis and causing the substrate to make a circular motion; an actuator configured to move the at least one movable shaft in a direction closer to and away from the reference shaft; a processing tool configured to contact a surface of the rotating and circularly moving substrate to thereby process the surface of the substrate; a distance sensor configured to measure a movement distance of the movable shaft when the movable shaft moves closer to and away from the reference shaft, and further to be able to detect that the notch has passed through the movable shaft; and a controller to which the notch detection sensor and the distance sensor is coupled, wherein the controller is configured: to issue an alarm when measured value of the distance sensor is out of a predetermined allowable range, and the distance sensor is not detecting the notch; and not to issue an alarm when the measured value of the distance sensor is out of the predetermined allowable range, and the distance sensor is detecting the notch.

In one embodiment, the controller is configured to cancel the alarm, during a predetermined rotation angle of the roller before and after a time point of detection of the notch by the distance sensor, even if the measured value of the distance sensor is out of the predetermined allowable range.

### Advantageous Effects of Invention

According to the present invention, the notch detection sensor or the distance sensor monitors whether or not the substrate is rotating properly, and thus an alarm is issued when there is an abnormality in the rotation of the wafer W. As a result, the substrate can be processed while monitoring whether or not the substrate is properly held by the rollers.

### Brief Description of Drawings

[FIG. 1] FIG. 1 is a plan view schematically showing a substrate processing apparatus according to one embodiment;
[FIG. 2] FIG. 2 is a side view showing the substrate processing apparatus shown in FIG. 1;
[FIG. 3] FIG. 3 is a bottom view showing the substrate processing apparatus shown in FIG. 1;
[FIG. 4A] FIG. 4A is schematic view illustrating operations of a substrate holding apparatus when receiving a wafer;
[FIG. 4B] FIG. 4B is schematic view illustrating operations of the substrate holding apparatus when receiving the wafer;
[FIG. 4C] FIG. 4C is schematic view illustrating operations of the substrate holding apparatus when receiving the wafer;
[FIG. 4D] FIG. 4D is schematic view illustrating operations of the substrate holding apparatus when receiving the wafer;
[FIG. 5] FIG. 5 is a schematic view showing an actuator 18 according to an embodiment; [FIG. 6] FIG. 6 is a cross-sectional view schematically showing diaphragms according to an embodiment;
[FIG. 7A] FIG. 7A is a view showing a state of the actuator when a pressure in a first pressure chamber is higher than a pressure in a second pressure chamber;
[FIG. 7B] FIG. 7B is a view showing a state of the actuator when the pressure in the second pressure chamber is higher than the pressure in the first pressure chamber;
[FIG. 8] FIG. 8 is a graph showing an example of measured values of a notch detection sensor;
[FIG. 9] FIG. 9 is a graph showing an example of measured values of a distance sensor;
[FIG. 10] FIG. 10 is a schematic view showing another example of the distance sensor;
[FIG. 11A] FIG. 11A is a view showing an example of measured values of the distance sensor, and
[FIG. 11B] FIG. 11B is a view showing an example of measured values of the notch detection sensor.

### Description of Embodiments

Hereinafter, embodiments will now be described with reference to the drawings.

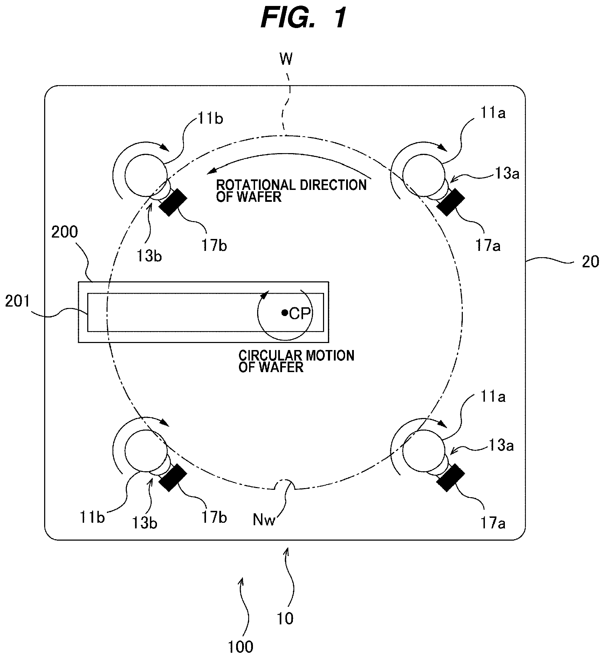

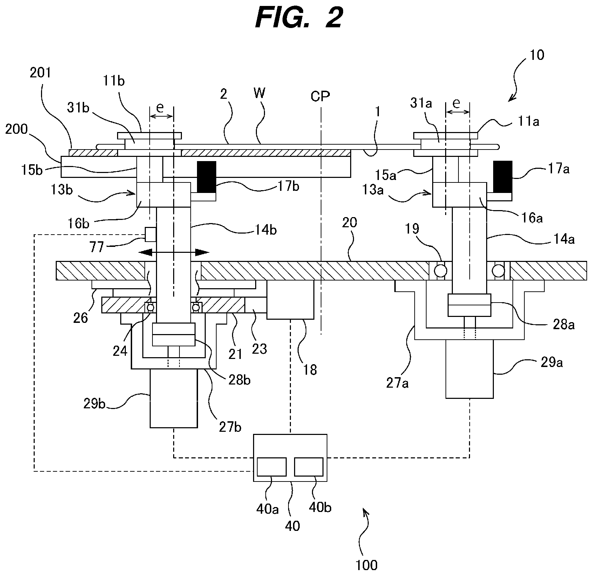

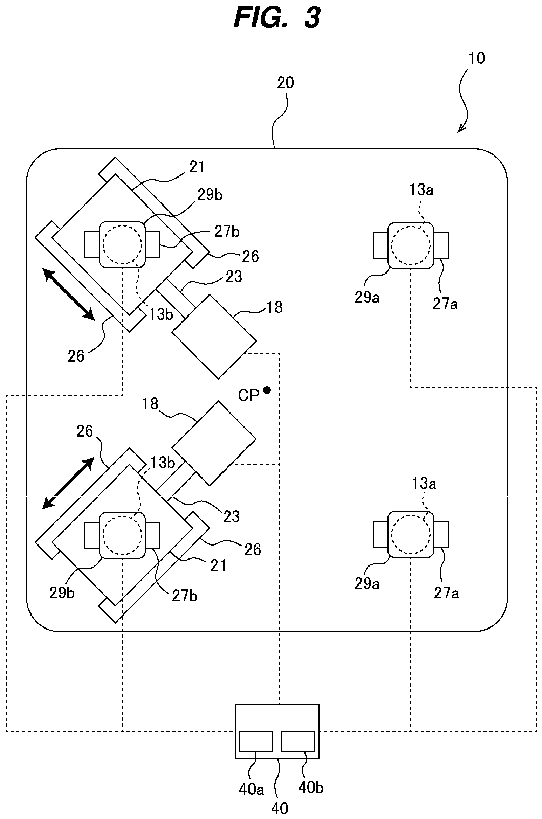

FIG. 1 is a plan view schematically showing a substrate processing apparatus according to one embodiment, FIG. 2 is a side view showing the substrate processing apparatus shown in FIG. 1, and FIG. 3 is a bottom view showing the substrate processing apparatus shown in FIG. 1. In FIG. 3, a processing tool shown in FIG. 1 is not illustrated. The substrate processing apparatus 100 shown in FIGS. 1 through 3 has a substrate holding apparatus 10 configured to cause a wafer W, which is an example of a substrate, to make a circular motion and rotate the wafer W about its axis, while holding the wafer W.

The substrate holding apparatus 10 includes a plurality of rollers 11a and a plurality of rollers 11b, both of which are capable of contacting a periphery of the wafer W, a plurality of electric motors 29a and a plurality of electric motors 29b for rotating the rollers 11a, 11b, respectively, a plurality of eccentric shafts 13a and a plurality of eccentric shafts 13b coupling the rollers 11a, 11b and the electric motors 29a, 29b to each other, respectively, and a controller 40 for causing the electric motors 29a, 29b to rotate at the same speed with the same phase.

The controller 40 includes at least one computer. The controller 40 includes a memory 40a and an arithmetic device 40b. The arithmetic device 40b includes a CPU (Central Processing Unit) or a GPU (Graphic Processing Unit) that performs arithmetic operations according to instructions contained in a program stored in the memory 40a. The memory 40a includes a main memory (for example, a random access memory) that can be accessed by the arithmetic device 40b, and an auxiliary memory (for example, a hard disk drive or a solid state drive) that stores data and the program.

Each roller 11a has a wafer holding surface (or a substrate holding surface) 31a for holding the periphery of the wafer W, and each roller 11b has a wafer holding surface (or a substrate holding surface) 31b for holding the periphery of the wafer W. Each roller 11a and each roller 11b have the same structure and the same size. The eccentric shafts 13a, 13b are arranged around a predetermined central axis CP of the substrate holding apparatus 10.

The substrate holding apparatus 10 in this embodiment includes two rollers 11a, two rollers 11b, two eccentric shafts 13a, two eccentric shafts 13b, two electric motors 29a, and two electric motors 29b. It is noted, however, that the number of each of these components is not limited to those of this embodiment.

Each of the eccentric shafts 13a has a first shaft portion 14a, a second shaft portion 15a which is eccentric relative to the first shaft portion 14a, and an intermediate shaft portion 16a that couples the first shaft portion 14a to the second shaft portion 15a. At least two of the first shaft portion 14a, the second shaft portion 15a, and the intermediate shaft portion 16a may be an integrated structure. For example, the first shaft portion 14a and the intermediate shaft portion 16a may be an integrated structure. In another example, all of the first shaft portion 14a, the second shaft portion 15a, and the intermediate shaft portion 16a in its entirety may be an integrated structure. Each of the eccentric shafts 13a shown in FIG. 2 has a shape of a crankshaft, but the shape of each of the eccentric shafts 13a is not limited to this embodiment as long as the second shaft portion 15a is eccentric by a predetermined distance from the first shaft portion 14a.

The rollers 11a are secured to ends of the second shaft portions 15a, respectively, and the other ends of the second shaft portions 15a are secured to the intermediate shaft portions 16a, respectively. Ends of the first shaft portions 14a are coupled to the electric motors 29a through couplings 28a, respectively, and the other ends of the first shaft portions 14a are secured to the intermediate shaft portions 16a, respectively.

Each of the eccentric shafts 13b has a first shaft portion 14b, a second shaft portion 15b which is eccentric relative to the first shaft portion 14b, and an intermediate shaft portion 16b that couples the first shaft portion 14b to the second shaft portion 15b. At least two of the first shaft portion 14b, the second shaft portion 15b, and the intermediate shaft portion 16b may be an integrated structure. For example, the first shaft portion 14b and the intermediate shaft portion 16b may be an integrated structure. In another example, all of the first shaft portion 14b, the second shaft portion 15b, and the intermediate shaft portion 16b in its entirety may be an integrated structure. Each of the eccentric shafts 13b shown in FIG. 2 has a shape of a crankshaft, but the shape of each of the eccentric shafts 13b is not limited to this embodiment as long as the second shaft portion 15b is eccentric by a predetermined distance from the first shaft portion 14b.

The rollers 11b are secured to ends of the second shaft portions 15b, respectively, and the other ends of the second shaft portions 15b are secured to the intermediate shaft portions 16b, respectively. Ends of the first shaft portions 14b are coupled to the electric motors 29b through couplings 28b, respectively, and the other ends of the first shaft portions 14b are secured to the intermediate shaft portions 16b, respectively.

Each electric motor 29a is configured to rotate the eccentric shaft 13a about the first shaft portion 14a, and each electric motor 29b is configured to rotate the eccentric shaft 13b about the first shaft portion 14b. The electric motors 29a, 29b are coupled to the controller 40.

The second shaft portion 15a of each eccentric shaft 13a is eccentric by a distance e from the first shaft portion 14a. Accordingly, when the electric motor 29a is set in motion, the roller 11a, while rotating about the second shaft portion 15a, makes a circular motion with a radius e. An axis of the roller 11a coincides with an axis of the second shaft portion 15a. Therefore, the roller 11a, while rotating about its axis, makes a circular motion with the radius e around the axis of the first shaft portion 14a.

Similarly, the second shaft portion 15b of each eccentric shaft 13b is eccentric by a distance e from the first shaft portion 14b. Accordingly, when the electric motor 29b is set in motion, the roller 11b, while rotating about the second shaft portion 15b, makes a circular motion with a radius e. An axis of the roller 11b coincides with an axis of the second shaft portion 15b. Therefore, the roller 11b, while rotating about its axis, makes a circular motion with the radius e around the axis of the first shaft portion 14b. In this specification, the circular motion is defined as a movement of an object in a circular orbit.

Operations of the electric motors 29a, 29b are controlled by the controller 40. As described above, the controller 40 is configured to cause all the electric motors 29a, 29b to rotate at the same speed with the same phase. More specifically, the controller 40 instructs the electric motors 29a, 29b such that all the electric motors 29a, 29b start at the same timing and all the electric motors 29a, 29b rotate in the same direction. Further, the controller 40 synchronizes the respective rotational speeds and the respective phases of the electric motors 29a, 29b during the operations of the electric motors 29a, 29b.

As a result, all the eccentric shafts 13a, 13b rotate about the axes of the first shaft portions 14a, 14b in the same direction at the same rotational speed with the same phase. All the rollers 11a, 11b make a circular motion about the axes of the first shaft portions 14a, 14b while rotating about their own axes of the rollers 11a, 11b in the same direction at the same rotational speed with the same phase. Therefore, when the controller 40 sets the electric motors 29a, 29b in motion, the wafer W, held by the rollers 11a, 11b, makes a circular motion with the radius e, while rotating about the axis of the wafer W.

Thus, the substrate holding apparatus 10, with its simple configuration, can rotate the wafer W about its axis while causing the wafer W to make a circular motion. The combination of the circular motion of the wafer W and the rotation of the wafer W about its axis can increase speed of the wafer W at any point on the surface of the wafer W. Therefore, when a processing head 200, which will be described later, is pressed against the surface of the wafer W, a relative speed between the processing head 200 and the surface of the wafer W can be increased, thereby increasing a processing rate of the wafer W.

A counter weight 17a and a counter weight 17b are secured to each eccentric shaft 13a and each eccentric shaft 13b, respectively. More specifically, the counter weights 17a, 17b are secured to the intermediate shaft portions 16a, 16b, respectively. The counter weight 17a and the roller 11a are arranged symmetrically with respect to the first shaft portion 14a. The counter weight 17a has a weight set such that a centrifugal force, which is generated in the radial direction from the first shaft portion 14a toward the roller 11a when the eccentric shaft 13a is rotating about the first shaft portion 14a, is canceled by a centrifugal force generated in the counter weight 17a.

Similarly, the counter weight 17b and the roller 11b are arranged symmetrically with respect to the first shaft portion 14b. The counter weight 17b has a weight set such that a centrifugal force, which is generated in the radial direction from the first shaft portion 14b toward the roller 11b when the eccentric shaft 13b is rotating about the first shaft portion 14b, is canceled by a centrifugal force generated in the counter weight 17b. Such counter weights 17a, 17b can prevent vibration of the eccentric shafts 13a, 13b due to weight imbalance during rotation of the eccentric shafts 13a, 13b.

The substrate holding apparatus 10 further includes a base plate 20, a plurality of linear motion guides 26 secured to a lower surface of the base plate 20, a plurality of movable bases 21 supported by the linear motion guides 26, and a plurality of actuators 18 coupled to the movable bases 21. Each linear motion guide 26 is configured to restrict movement of each movable base 21 to a linear movement in a direction parallel to the lower surface of the base plate 20.

Each movable base 21 has a bearing 24 which rotatably supports the eccentric shaft 13b, and a coupling member 23 coupled to each actuator 18. The actuators 18 are coupled to the eccentric shafts 13b through the movable bases 21, respectively. The movable bases 21, which include the bearings 24, respectively, are independently moved together with the eccentric shafts 13b by the actuators 18, respectively.

The actuators 18 are secured to the lower surface of the base plate 20. The operations of the actuators 18 are controlled by the controller 40. The controller 40 is configured to be able to operate the actuators 18 independently of each other. Each actuator 18 is configured to move each movable base 21 in parallel with the base plate 20.

The eccentric shafts 13a extend through the base plate 20. The rollers 11a are arranged above the base plate 20, while the electric motors 29a are arranged below the base plate 20. The eccentric shafts 13a are rotatably supported by bearings 19 held on the base plate 20. Positions of these eccentric shafts 13a are fixed. The electric motors 29a are secured to the base plate 20 through electric motor support members 27a, respectively. More specifically, the electric motor support members 27a are secured to the lower surface of the base plate 20, and the electric motors 29a are secured to the electric motor support members 27a, respectively.

The eccentric shafts 13b extend through the movable bases 21 and the base plate 20. The rollers 11b are arranged above the base plate 20, while the electric motors 29b are arranged below the base plate 20. The eccentric shafts 13b are rotatably supported by the bearings 24 of the movable bases 21, respectively. The electric motors 29b are secured to the movable bases 21 through electric motor support members 27b, respectively. More specifically, the electric motor support members 27b are secured to the lower surface of the movable bases 21, and the electric motors 29b are secured to the electric motor support members 27b, respectively.

According to the above-described construction, the eccentric shafts 13a are reference shafts that cannot move relative to the base plate 20, while the eccentric shafts 13b are movable shafts that can move relative to the base plate 20. In the following descriptions, the eccentric shafts 13a may be referred to as reference shafts 13a, and the eccentric shafts 13b may be referred to as movable shafts 13b. The actuators 18 are coupled to the movable shafts 13b through the movable bases 21. Each movable base 21 has the bearing 24 which rotatably supports the movable shaft 13b, and the coupling member 23 coupled to the actuator 18. Therefore, the movable base 21 couples the actuator 18 to the movable shaft 13b.

The actuators 18 can move the movable shafts 13b through the movable bases 21 in parallel with the base plate 20. Specifically, the actuators 18 are configured to move the movable shafts 13b in a direction closer to the reference shafts 13a and in a direction away from the reference shafts 13a. When the two movable shafts 13b move in the direction closer to the reference shafts 13a, the wafer W is held by the two rollers 11a and the two rollers 11b. When the two movable shafts 13b move in the direction away from the two reference shafts 13a, the wafer W is released from the two rollers 11a and the two rollers 11b.

As shown in FIG. 3, in this embodiment, the actuators 18 and the linear motion guides 26 are oriented toward the central axis CP of the substrate holding apparatus 10. The actuators 18 move the movable shafts 13b in directions of arrows illustrated in FIG. 3. In this embodiment, the direction closer to the reference shafts 13a and the direction away from the reference shafts 13a corresponds to a direction toward the central axis CP and a direction away from the central axis CP. When the movable shafts 13b are moved in the direction toward the central axis CP, the rollers 11b can hold the wafer W with clamping forces acting toward the center of the wafer W. With the construction in this embodiment, the substrate holding apparatus 10 can efficiently hold the wafer W with a minimum force. In one embodiment, each of the actuators 18 and each of the linear motion guides 26 may be oriented toward each of the reference shafts 13a.

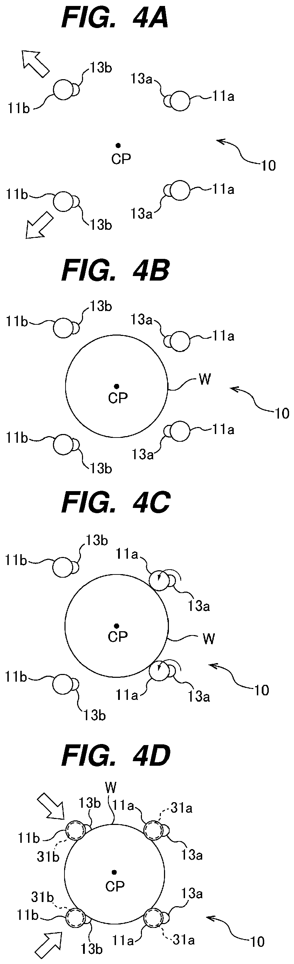

FIGS. 4A through 4D are schematic views each illustrating operations of the substrate holding apparatus 10 when receiving the wafer W. As shown in FIG. 4A, before the substrate holding apparatus 10 receives the wafer W, each actuator 18 (see FIGS. 2 and 3) is operated to move each roller 11b in the direction away from the central axis CP. At this time, the rollers 11a and the rollers 11b are eccentric outwardly.

Next, as shown in FIG. 4B, the wafer W is transported to the substrate holding apparatus 10 by a not-shown transport device. Further, as shown in FIG. 4C, with the wafer W located between the rollers 11a and the rollers 11b, the reference shafts 13a are rotated 180 degrees to move the rollers 11a inwardly. Thereafter, as shown in FIG. 4D, the actuators 18 are actuated to move the rollers 11b and the movable shafts 13b in the direction closer to the reference shafts 13a until the rollers 11b come into contact with the wafer W.

In this manner, the periphery of the wafer W is held by the wafer holding surfaces 31a of the rollers 11a and the wafer holding surfaces 31b of the rollers 11b. When the wafer W is to be removed from the substrate holding apparatus 10, the steps shown in FIGS. 4A through 4D are performed in the reverse order.

In the embodiments described above, the two movable shafts 13b are supported by the two movable bases 21, respectively, and further coupled to the two actuators 18, respectively. Accordingly, even when vibration occurs in one movable shaft 13b during rotation of the wafer W, the above discussed configurations can prevent the vibration from propagating to the other movable shaft 13b. As a result, the substrate holding apparatus 10 can stably hold the wafer W.

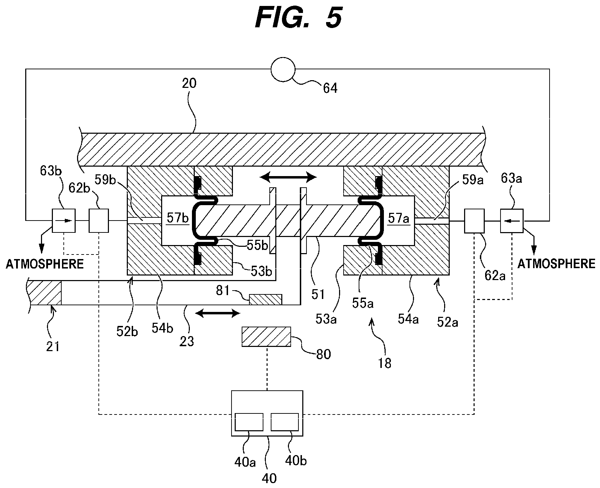

FIG. 5 is a schematic view showing the actuator 18 according to an embodiment. Each actuator 18 includes a piston 51 arranged in a longitudinal direction of the actuator 18, housings 52a, 52b arranged outwardly of the piston 51, and separation membranes (i.e., diaphragms) 55a, 55b which form pressure chambers 57a, 57b between the piston 51 and the housings 52a, 52b. The piston 51 is configured to be movable in directions indicated by arrows in FIG. 5 (i.e., in the longitudinal direction of the actuator 18). The housings 52a, 52b are arranged away from the piston 51. The housing 52a is arranged so as to surround one end of the piston 51, and the housing 52b is arranged so as to surround the other end of the piston 51.

The coupling member 23 of the movable base 21 is coupled to the piston 51, and thus the piston 51 is supported by the coupling member 23. The movable base 21, including the coupling member 23, is configured to be movable together with the piston 51 in directions indicated by arrows in FIG. 5. More specifically, the movable base 21 is configured to be movable together with the piston 51 in the direction closer to the reference shaft 13a and in the direction away from the reference shaft 13a. In this embodiment, since the actuator 18 is oriented toward the central axis CP of the substrate holding apparatus 10 (see FIG. 3), the moving directions of the piston 51 and the movable base 21 correspond to the direction toward the central axis CP and the direction away from the central axis CP.

The housings 52a, 52b include, respectively, housing bodies 53a, 53b, each which is arranged so as to surround a side surface of the piston 51, and lids 54a, 54b, each which is fixed to the housing bodies 53a, 53b. A rim of the diaphragm 55a is sandwiched between the housing body 53a and the lid 54a. Similarly, a rim of the diaphragm 55b is sandwiched between the housing body 53b and the lid 54b.

The pressure chamber 57a is formed by the diaphragm 55a and an inner surface of the housing 52a. Similarly, the pressure chamber 57b is formed by the diaphragm 55b and an inner surface of the housing 52b. More specifically, the pressure chamber 57a is formed by the diaphragm 55a and an inner surface of the lid 54a, and the pressure chamber 57b is formed by the diaphragm 55b and an inner surface of the lid 54b. The diaphragms 55a, 55b have the same structure. In this embodiment, the housings 52a, 52b have the same structure, but may have different structures to each other.

Compressed-gas flow passages 59a, 59b are formed in the lids 54a, 54b of the housings 52a, 52b, respectively. The compressed-gas flow passages 59a, 59b are coupled to a compressed-gas supply source 64 via pressure regulators 62a, 62b and switching valves 63a, 63b. The pressure chambers 57a, 57b communicate with the pressure regulators 62a, 62b through the compressed-gas flow passages 59a, 59b, respectively.

When the piston 51 is to be moved, the switching valves 63a, 63b are operated to allow the pressure chambers 57a, 57b to communicate with the compressed-gas supply source 64. In this embodiment, the switching valves 63a, 63b are coupled to the controller 40. The switching valves 63a, 63b are valves for allowing the pressure chambers 57a, 57b to communicate with the compressed-gas supply source 64 or the atmosphere selectively. Three-way valves may be used as the switching valves 63a, 63b.

A compressed gas, such as compressed air, is supplied from the compressed-gas supply source 64 through the compressed-gas flow passages 59a, 59b into the pressure chambers 57a, 57b. Examples of the compressed-gas supply source 64 may include a pump, and a compressed-gas supply line which has been pre-installed as a utility in a factory. Pressures of the compressed gas in the pressure chambers 57a, 57b are regulated by the pressure regulators 62a, 62b, respectively. In this embodiment, the pressure regulators 62a, 62b are electro-pneumatic regulators. The pressure regulators 62a, 62b in this embodiment are coupled to the controller 40. In one embodiment, the pressure regulators 62a, 62b may be manually operated pressure regulators. In this case, the pressure regulators 62a, 62b are not coupled to the controller 40.

The controller 40 transmits predetermined set pressure values to the pressure regulators 62a, 62b, respectively. The pressure regulators 62a, 62b are configured to regulate the pressures of the compressed gas in the pressure chambers 57a, 57b according to the set pressure values. Examples of such pressure regulators 62a, 62b may include electro-pneumatic regulators, and mechanical regulators. In one embodiment, the pressure regulator 62b may be an electro-pneumatic regulator, while the pressure regulator 62a may be a mechanical regulator. In the case where the pressure regulator 62a is the mechanical regulator, the pressure regulator 62a is not coupled to the controller 40.

The piston 51 moves in response to a difference between the pressure in the pressure chamber 57a and the pressure in the pressure chamber 57b. When the pressure in the pressure chamber 57a becomes higher than the pressure in the pressure chamber 57b, the piston 51 is moved in the direction away from the reference shaft 13a (see FIG. 3). When the pressure in the pressure chamber 57b becomes higher than the pressure in the pressure chamber 57a, the piston 51 is moved in the direction closer to the reference shaft 13a (see FIG. 3).

In this embodiment, when the piston 51 is to be moved, the compressed gas is introduced into both the pressure chambers 57a, 57b such that the pressure of the compressed gas in one of the pressure chambers 57a, 57b is higher than the pressure of the compressed gas in the other. In one embodiment, when the piston 51 is to be moved, the compressed gas may be introduced into only one of the pressure chamber 57a and the pressure chamber 57b, and the other may communicate with the atmosphere.

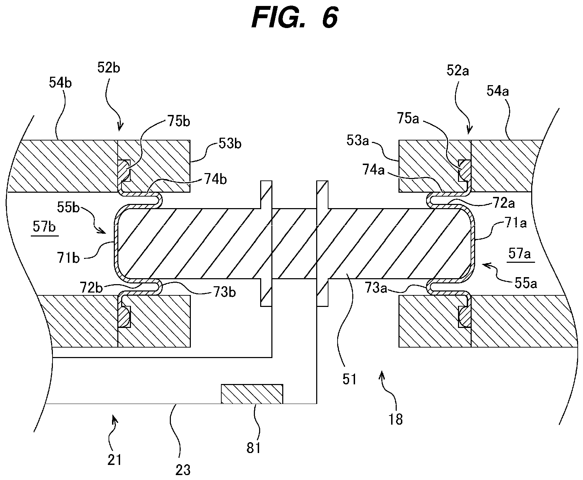

FIG. 6 is a cross-sectional view schematically showing the diaphragms 55a, 55b according to an embodiment. The diaphragm 55a has a central portion 71a in contact with one end of the piston 51, an inner wall portion 72a connected to the central portion 71a and extending along the side surface of the piston 51, a folded-back portion 73a connected to the inner wall portion 72a and having a curved cross section, and an outer wall portion 74a connected to the folded-back portion 73a and located outside the inner wall portion 72a. The diaphragm 55a is in contact with one end of the piston 51. When the compressed gas is introduced into the pressure chamber 57a, the outer wall portion 74a contacts the inner surface of the housing body 53a.

In this embodiment, the central portion 71a has a circular shape. The inner wall portion 72a and the outer wall portion 74a each have a cylindrical shape, and the inner wall portion 72a is in contact with the side surface of the piston 51. The outer wall portion 74a is arranged so as to surround the inner wall portion 72a.

Similarly, the diaphragm 55b has a central portion 71b in contact with the other end of the piston 51, an inner wall portion 72b connected to the central portion 71b and extending along the side surface of the piston 51, a folded-back portion 73b connected to the inner wall portion 72b and having a curved cross section, and an outer wall portion 74b connected to the folded-back portion 73b and located outside the inner wall portion 72b. The diaphragm 55b is in contact with the other end of the piston 51. When the compressed gas is introduced into the pressure chamber 57b, the outer wall portion 74b contacts the inner surface of the housing body 53b.

In this embodiment, the central portion 71b has a circular shape. The inner wall portion 72b and the outer wall portion 74b each have a cylindrical shape, and the inner wall portion 72b is in contact with the side surface of the piston 51. The outer wall portion 74b is arranged so as to surround the inner wall portion 72b.

The diaphragms 55a, 55b are in contact with the piston 51, but are not fixed to the piston 51. A thick portion 75a, constituting the rim of the diaphragm 55a, is sandwiched between the housing body 53a and the lid 54a. Similarly, a thick portion 75b, constituting the rim of the diaphragm 55b, is sandwiched between the housing body 53b and the lid 54b. The diaphragms 55a, 55b are made of flexible material. Examples of material constructing the diaphragms 55a, 55b may include chloroprene rubber, fluoro-rubber, and silicone rubber. Chloroprene rubber having a high resistance to flex fatigue is preferably used.

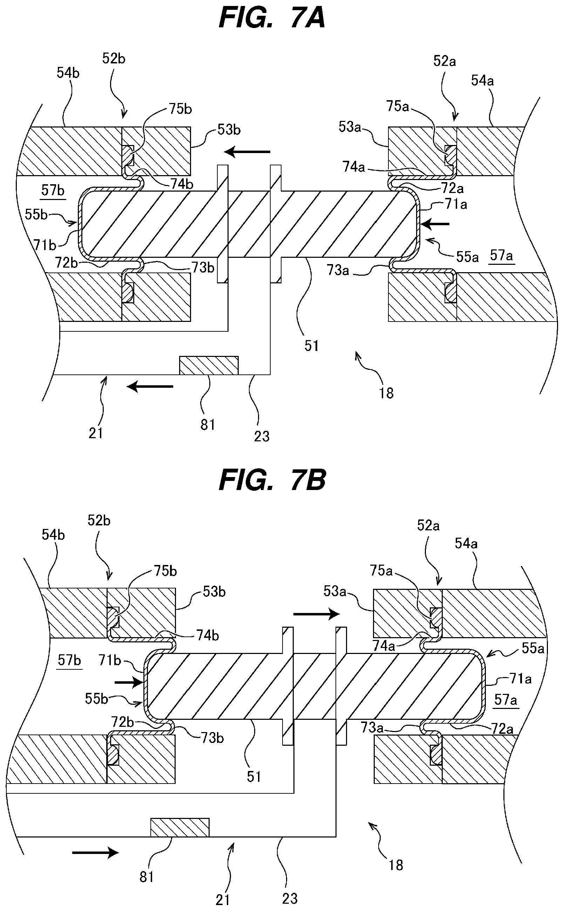

FIG. 7A is a view showing a state of the actuator 18 when the pressure in the pressure chamber 57a (first pressure chamber 57a) is higher than the pressure in the pressure chamber 57b (second pressure chamber 57b). FIG. 7B is a view showing a state of the actuator 18 when the pressure in the pressure chamber 57b is higher than the pressure in the pressure chamber 57a.

As shown in FIG. 7A, when the pressure in the pressure chamber 57a becomes higher than the pressure in the pressure chamber 57b, a force in a direction toward the pressure chamber 57b is applied to the piston 51. As a result, the piston 51, the movable base 21, and the movable shaft 13b move in unison in the direction away from the reference shaft 13a(see FIG. 3) while the diaphragms 55a, 55b are deformed. At this time, while the folded-back portion 73a retains its shape, a part of the inner wall portion 72a becomes a part of the folded-back portion 73a, and a part of the folded-back portion 73a becomes a part of the outer wall portion 74a. At the same time, while the folded-back portion 73b retains its shape, a part of the outer wall portion 74b becomes a part of the folded-back portion 73b, and a part of the folded-back portion 73b becomes a part of the inner wall portion 72b.

As shown in FIG. 7B, when the pressure in the pressure chamber 57b becomes higher than the pressure in the pressure chamber 57a a force in a direction toward the pressure chamber 57a is applied to the piston 51. As a result, the piston 51, the movable base 21, and the movable shaft 13b move in unison in the direction closer to the reference shaft 13a (see FIG. 3) while the diaphragm 55b is deformed. At this time, while the folded-back portion 73b retains its shape, a part of the inner wall portion 72b becomes a part of the folded-back portion 73b, and a part of the folded-back portion 73b becomes a part of the outer wall portion 74b. At the same time, while the folded-back portion 73a retains its shape, a part of the outer wall portion 74a becomes a part of the folded-back portion 73a, and a part of the folded-back portion 73a becomes a part of the inner wall portion 72a.

Such motions of the diaphragms 55a, 55b enable the piston 51 to move smoothly while the piston 51 hardly receives a reaction force from the diaphragms 55a, 55b. If a piston and a housing are in contact with each other as in a typical air cylinder, a sliding resistance is generated between the piston and the housing when vibration occurs during rotation of a wafer. Such sliding resistance exerts an excessive load on a rotating wafer, thus causing unstable holding of the wafer. In this embodiment, since the housings 52a, 52b are arranged away from the piston 51, no sliding resistance is generated between the piston 51 and the housings 52a, 52b. As a result, the substrate holding apparatus 10 can stably hold the wafer W without exerting an excessive load on the wafer W.

In the embodiments shown in FIGS. 1 through 3, the substrate holding apparatus 10 includes the two reference shafts 13a, the two movable shafts 13b, the two actuators 18, the two movable bases 21, and the two linear motion guides 26 arranged around the central axis CP, while the number and interval of arrangements of these components are not limited to this embodiment. In one embodiment, the substrate holding apparatus 10 may include one movable shaft 13b and two or more reference shafts 13a arranged around the central axis CP at appropriate intervals. In this arrangement, the substrate holding apparatus 10 includes one actuator 18, one movable base 21, and one linear motion guide 26.

Further, in one embodiment, the substrate holding apparatus 10 may include three or more movable shafts 13b, and three or more reference shafts 13a arranged around the central axis CP at appropriate intervals. In this arrangement, the substrate holding apparatus 10 includes three or more actuators 18, three or more movable bases 21, and three or more linear motion guides 26.

In this embodiment, the substrate processing apparatus 100 further includes a processing head 200 for bringing a processing tool 201 into contact with a first surface 1 of the wafer W, held by the substrate holding apparatus 10, to thereby process the first surface 1. The processing head 200 is located below the wafer W held by the substrate holding apparatus 10, and a position of the processing head 200 is fixed.

The first surface 1 of the wafer W is a back surface of the wafer W, i.e. a non-device surface, where no device is formed or no device is to be formed. A second surface 2 of the wafer W, which is opposite from the first surface 1, is a front surface, i.e. a device surface, where a device(s) is formed or a device(s) is to be formed. The wafer W, with its first surface 1 facing downward, is horizontally held by the substrate holding apparatus 10.

Detailed operation of the substrate processing apparatus 100 according to this embodiment is as follows. The substrate holding apparatus 10 brings the plurality of rollers 11a and the plurality of rollers 11b into contact with the periphery of the wafer W, and rotates the rollers 11a, 11b about their respective own axes, and further causes the rollers 11a, 11b to make a circular motion, thereby rotating the wafer W, which is held by the rollers 11a, 11b, about its axis and causing the wafer W to make a circular motion. In this state, the processing head 200 places the processing tool 201 in contact with the first surface 1 of the wafer W to thereby process the first surface 1.

In this embodiment, the processing tool 201 is longer than a radius of the wafer W. One end of the processing tool 201 protrudes outwardly from the periphery of the wafer W, while the other end of the processing tool 201 extends across the central axis CP of the substrate holding apparatus 10. Accordingly, the processing head 200 can bring the processing tool 201 into contact with the entirety of the first surface 1 of the rotating wafer W. As a result, this configuration enables the processing tool 201 to process the entirety of the first surface 1, including the outermost area, of the wafer W. The processing head 200 is located in such a position as not to contact the rollers 11a, 11b and the eccentric shafts 13a, 13b when the wafer W is making a circular motion.

As described above, the substrate holding apparatus 10, with its simple structure, can rotate the wafer W about its axis while allowing the wafer W to make a circular motion. The combination of the circular motion of the wafer W and the rotation of the wafer W about its axis can increase the speed of the wafer W at any point on the surface of the wafer W. Therefore, the relative speed between the processing tool 201 and the surface of the wafer W can be increased, thereby increasing a processing rate of the wafer W.

In one embodiment, the processing tool 201 may be a polishing tool for polishing the first surface 1 of the wafer W. Examples of the polishing tool may include a polishing tape, and a grindstone. Further, in one embodiment, the processing tool 201 may be a cleaning tool for cleaning the first surface 1 of the wafer W. A cleaning tape is an example of the cleaning tool. A tape made of nonwoven fabric is an example of the cleaning tape.

Although not shown in the drawings, the substrate processing apparatus 100 may include the processing head 200 that processes the second surface 2 of the wafer W by bringing the processing tool 201 into contact with the second surface 2 of the wafer W held by the substrate holding device 10. For example, the processing tool 201 may be a cleaning tool for cleaning the second surface 2 of the wafer W. In this case, the processing head 200 is located above the wafer W held by the substrate holding device 10.

As shown in FIG. 2, the substrate holding device 10 of the substrate processing apparatus 100 has a notch detection sensor 77. In the example shown in FIG. 2, the notch detection sensor 77 is mounted to one of the movable shafts 13b. In one embodiment, the notch detection sensor 77 may be mounted to any of the movable base 21, the electric motor support member 27b, the coupling 28b, and the electric motor 29b.

The notch detection sensor 77 is a sensor capable of detecting whether or not a notch Nw (see FIG. 1) of the wafer W passes through the movable shaft 13b to which the notch detection sensor 77 is mounted. The notch detection sensor 77 is coupled to the controller 40, and transmits measured values thereof to the controller 40. In the example shown in FIG. 2, as the notch detection sensor 77, an acceleration sensor is used. In one embodiment, a vibration sensor may be used as the notch detection sensor 77.

When the notch Nw of the wafer W passes through the movable shaft 13b to which the notch detection sensor 77 is mounted, the movable shaft 13b moves closer to and away from the reference shaft 13a according to the shape of the notch Nw (in the example shown in FIG. 1, a shape of circular arc). As a result, relatively large acceleration or vibration is generated in the movable shaft 13b.

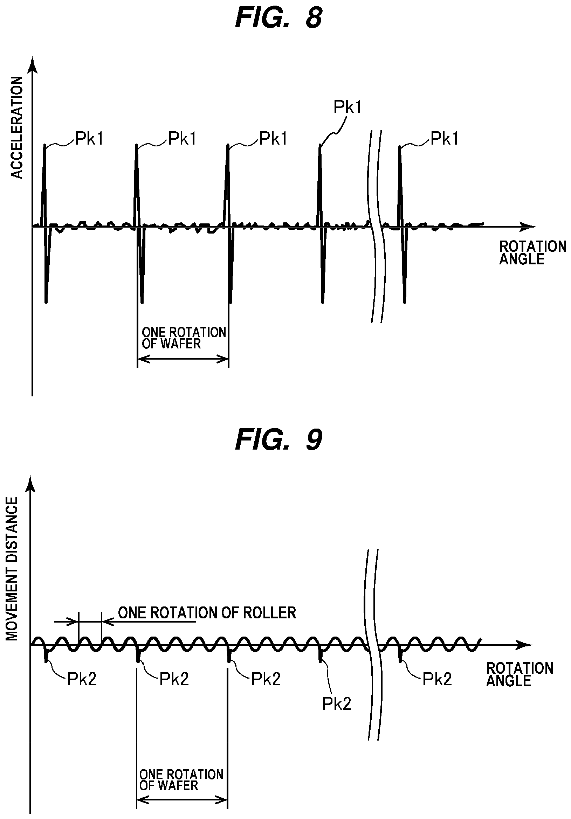

FIG. 8 is a graph showing an example of the measured values of the notch detection sensor. In FIG. 8, a vertical axis represents an acceleration of the movable shaft 13b, to which the notch detection sensor 77 is mounted, in the horizontal direction, and a horizontal axis represents a rotation angle of the first shaft portion 14b in the movable shaft 13b to which the notch detection sensor 77 is mounted.

In the graph shown in FIG. 8, a characteristic plurality of waveforms Pk1 having a large peak, respectively, correspond to waveforms that represent passage of the notch Nw of the wafer W through the movable shaft 13b. In the following, the waveform Pk1 may be referred to as "passing waveform Pk1". During adjacent passing waveforms Pk1, the wafer W held by the plurality of rollers 11a, 11b makes one rotation. Typically, the roller 11b rotates multiple times during the adjacent passing waveforms Pk1. The controller 40 can create the graph shown in FIG. 8 from the measured values of the notch detection sensor 77.

The controller 40 monitors whether or not the wafer W is rotating at a desired rotational speed (or a set rotational speed) based on the measured values received from the notch detection sensor 77. For example, the controller 40 calculates the rotational speed of the wafer W based on the measured values received from the notch detection sensor 77, and compares the calculated rotational speed of the wafer W with an allowable range that has been determined with respect to a theoretical rotational speed of the wafer W, thereby determining whether or not the wafer W is rotating at the desired rotational speed. The theoretical rotational speed of the wafer W can be calculated from a diameter of the wafer W, diameters of the rollers 11a, 11b, and rotational speeds of the electric motors 29a, 29b. The theoretical rotational speed of the wafer W may be calculated from a ratio of the diameter of the wafer W to the diameters of the rollers 11a, 11b, and the rotational speeds of the electric motors 29a, 29b. The controller 40 stores in advance this theoretical rotational speed and the allowable range determined with respect to the theoretical rotational speed.

For example, the controller 40 can calculate the rotational speed of the wafer W from the number of passing waveforms Pk1 counted during a predetermined time interval (e.g., 10 seconds). In one embodiment, time between adjacent passing waveforms Pk1 (i.e., time during one rotation of the wafer W) can be counted, and then the rotational speed of the wafer W can be calculated based on this counted time.

The controller 40 is configured to compare the rotational speed of the wafer W, which is calculated based on the measured values of the notch detection sensor 77, with the allowable range, and to issue an alarm when the rotational speed of the wafer W is out of the allowable range. The alarm enables operator for the substrate processing apparatus to realize that an abnormal rotation of the wafer W has occurred, and as a result, to check whether or not a processing abnormality has occurred on the wafer W. In one embodiment, the controller 40 may issue an alarm and further stop the processing operation of the wafer W. Alternatively, the controller 40 may store a signal to identify the wafer W that was being processed when the alarm was issued, in association with the wafer W, and continue the processing operation of the wafer W.

Examples of causing the rotational speed of the wafer W calculated based on the measured values of the notch detection sensor 77 to exceed an upper limit of the allowable range may include a defect in the wafer W, a defect in the rollers 1 1a, 11b, and an abnormal rotation of the electric motors 29a, 29b. The alarm enables operator to quickly check status of the wafer W, the rollers 11a, 11b, and the electric motors 29a, 29b, and perform, if necessary, maintenance and/or replacement of the rollers 11a, 11b and the electric motors 29a, 29b.

Examples of causing the rotational speed of the wafer W calculated based on the measured values of the notch detection sensor 77 to fall below a lower limit of the allowable range include wear of the rollers 11a, 11b, and occurrence of slipping between the rollers 11a, 11b and the wafer W. In this case, there is a concern that processing performance in the substrate processing apparatus may be reduced (e.g., polishing performance may be reduced or cleaning performance may be reduced). The alarm enables operator to identify the wafer W on which the abnormal rotation of wafer W has occurred and to check whether that wafer W has any processing abnormality.

In one embodiment, when the rotational speed of the wafer W calculated based on the measured values of the notch detection sensor 77 falls below the lower limit of the allowable range, the controller 40 may perform additional processing to the wafer W based on a difference or a ratio between the rotational speed of the wafer W calculated based on the measured values of the notch detection sensor 77 and the theoretical rotational speed of the wafer W. For example, if the rotational speed of wafer W calculated based on the measured values of the notch detection sensor 77 is 10% lower than the theoretical rotational speed, the controller 40 may increase processing time by 10%. Alternatively, a relational equation or a data table between the ratio of the actual rotational speed to the theoretical rotational speed and the increased amount of processing time may be obtained in advance through experiments that have been carried out previously, and this relational equation or this data table may be stored in advance in the controller 40. In this case, the controller 40 calculates the ratio of the rotational speed of the wafer W calculated based on the measured values of the notch detection sensor 77 to the theoretical rotational speed, and calculates the increased amount of processing time from this ratio and the relational equation or the data table.

In the embodiments described above, the controller 40 calculates the rotational speed of the wafer W based on the measured values received from the notch detection sensor 77. However, in this specification, the rotational speed of the wafer W monitored by the controller 40 includes also a value corresponding to the rotational speed of the wafer W calculated based on the measured values of the notch detection sensor 77. For example, the controller 40 may monitor the number of passing waveforms Pk1 counted during a predetermined time interval (e.g., 10 seconds). In this case, the controller 40 stores in advance the theoretical number of passing waveforms Pk1 calculated from the theoretical rotational speed of the wafer W and an allowable range that is determined with respect to the theoretical number of passing waveforms Pk1. The controller 40 compares the counted number of passing waveforms Pk1 with the allowable range, and issues an alarm when the counted number of passing waveforms Pk1 is out of the allowable range. As described above, the controller 40 may issue an alarm, and further stop the processing operation of the wafer W in the substrate processing apparatus, or may store a signal to identify the wafer W that was processed when the alarm was issued, in association with the wafer W, and continue the processing operation of the wafer W in the substrate processing apparatus.

Next, the substrate processing apparatus 100 according to another embodiment will be described. As shown in FIG. 5, the substrate holding device 10 may have a noncontact type distance sensor 80 for measuring a movement distance of the movable shaft 13b, instead of the notch detection sensor 77 shown in FIG. 2. In this case, the distance sensor 80 serves as a sensor capable of detecting the position of the movable shaft 13a relative to the reference shaft 13a, and further is used as the notch detection sensor capable of detecting that the notch Nw (see FIG. 1) of the wafer W has passed. Configurations of this embodiment, which will not be particularly described, are the same as those of the substrate processing apparatus 100 having the notch detection sensor 77 shown in FIG. 2, and redundant descriptions thereof will be omitted.

The distance sensor 80 is arranged outside the actuator 18, and is located near the actuator 18 and the movable base 21. A magnet 81 is secured to the coupling member 23 of the movable base 21, and the distance sensor 80 faces the magnet 81. In this embodiment, the distance sensor 80 is a magnetic sensor, and can measure a distance of the movement of the magnet 81 relative to the distance sensor 80.

A position of the distance sensor 80 is fixed. On the other hand, the movable base 21, the piston 51, and the movable shaft 13b can move in unison. Therefore, when the movable shaft 13b moves in the direction closer to the reference shaft 13a and in the direction away from the reference shaft 13a, a relative position of the magnet 81 secured to the movable base 21 with respect to the distance sensor 80 is changed. A movement distance of the magnet 81 corresponds to the movement distance of the movable shaft 13b. Therefore, the distance sensor 80 can measure the movement distance of the movable shaft 13b. The movement distance of the movable shaft 13b means a position of the movable shaft 13b relative to a predetermined reference position. In the following descriptions, the position of the movable shaft 13b relative to the predetermined reference position may be simply referred to a position of the movable shaft 13b. The distance sensor 80 is coupled to the controller 40, and transmits a measured value of the movement distance of the movable shaft 13b to the controller 40.

When the notch Nw of the wafer W passes through the movable shaft 13b coupled to the movable base 21 to which the magnet 81 is mounted, the movable shaft 13b moves closer to and away from the reference shaft 13a according to the shape of the notch Nw (in the example shown in FIG. 1, a shape of circular arc). As a result, the distance sensor 80 can detect that the notch Nw has passed through the movable shaft 13b.

FIG. 9 is a graph showing an example of the measured values of the distance sensor shown in FIG. 5. In FIG. 9, a vertical axis represents a movement distance of the movable shaft 13b, to which the notch detection sensor 77 is mounted, and a horizontal axis represents a rotation angle of the first shaft portion 14b in the movable shaft 13b.

As shown in FIG. 9, a characteristic plurality of waveforms Pk2 having a large peak, respectively, correspond to waveforms that represent passage of the notch Nw of the wafer W through the movable shaft 13b. In the following, the waveform Pk2 may be referred to as "passing waveform Pk2". During adjacent passing waveforms Pk2, the wafer W held by the plurality of rollers 11a, 11b makes one rotation. Typically, the roller 11b rotates multiple times during the adjacent passing waveforms Pk2. The measured values of the distance sensor 80 plot an approximate sinusoidal wave during one rotation of the roller 11b. The controller 40 can create the graph shown in FIG. 9 from the measured values of the distance sensor 80.

Similar to the embodiments described above, the controller 40 calculates the rotational speed of the wafer W from the number of passing waveforms Pk2 counted during a predetermined time interval (e.g., 10 seconds), or time between adjacent passing waveforms Pk2 (i.e., time during one rotation of the wafer W), and monitors whether or not the wafer W is rotating at a desired rotational speed (or a set rotational speed). Further, the controller 40 compares the rotational speed of the wafer W, which is calculated based on the measured values of the distance sensor 80, with an allowable range that has been determined with respect to a theoretical rotational speed of the wafer W, thereby determining whether or not the wafer W is rotating at the desired rotational speed.

Next, the controller 40 is configured to issue an alarm when the rotational speed of the wafer W, which is calculated based on the measured values of the distance sensor 80, is out of the allowable range. In one embodiment, the controller 40 may issue the alarm and further stop the processing operation of the wafer W, or may store a signal to identify the wafer W that was being processed when the alarm was issued, in association with the wafer W, and may continue the processing operation of the wafer W. Further, similar to the embodiments described above, when the rotational speed of wafer W, calculated based on the measured values of distance sensor 80, falls below the lower limit of the allowable range, the controller 40 may perform an additional processing on the wafer W based on the difference or the ratio between the rotational speed of the wafer W, calculated based on the measured values of distance sensor 80, and the theoretical rotational speed of the wafer W. Furthermore, the controller 40 may use the number of passing waveforms Pk2 counted during the predetermined time interval (e.g., 10 seconds) as a monitoring target.

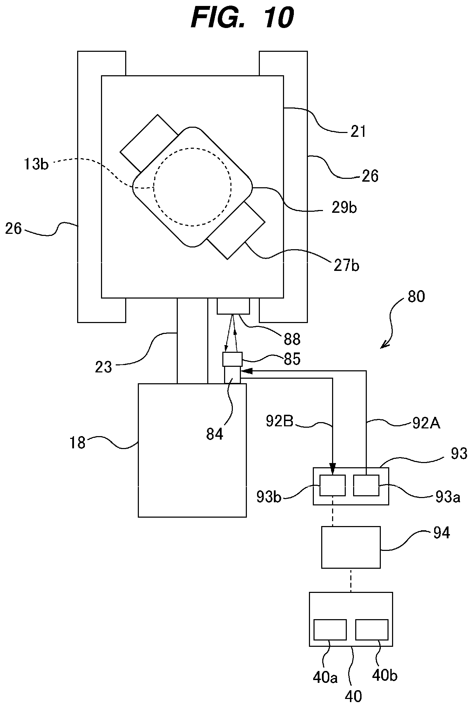

In one embodiment, as shown in FIG. 10, the distance sensor 80 may be a noncontact type optical sensor. The distance sensor 80 shown in FIG. 10 includes a sensor head 84 having a light-emitting element and a light-receiving element (both not shown) provided at a front end thereof, a converging lens 85 for converging light emitted from the sensor head 84, an amplifier 93 coupled to the sensor head 84 by a light-emitting optical fiber cable 92A and a light-receiving optical fiber cable 92B, and a distance calculator 94 electrically connected to the amplifier 93. The converging lens 85 is mounted to the front end of the sensor head 84.

The sensor head 84 is secured to an outside of the actuator 18, and the front end of the sensor head 84 is oriented toward the movable base 21. More specifically, in this embodiment, a sensor target 88 is mounted to the movable base 21, and the front end of the sensor head 84 is oriented toward the sensor target 88. The sensor target 88 has a property of reflecting light. An example of the sensor target 88 may include a member composed of ceramic or metal. The amplifier 93 and the distance calculator 94 are located away from the actuator 18.

The amplifier 93 has a light source 93a for emitting light, and a light-intensity measuring device 93b for measuring intensity of reflected light. The light emitted from the light source 93a of the amplifier 93 is transmitted through the light-emitting optical fiber cable 92A to the sensor head 84. The sensor head 84 directs the light to the sensor target 88 through the converging lens 85, and receives the reflected light from the sensor target 88. The reflected light is transmitted through the light-receiving optical fiber cable 92B to the amplifier 93.

The light-intensity measuring device 93b of the amplifier 93 measures the intensity of the reflected light. The amplifier 93 sends the measured value of intensity of the reflected light to the distance calculator 94, and the distance calculator 94 converts the measured value of the intensity of the reflected light into a distance. The distance obtained by the distance calculator 94 corresponds to the movement distance of the movable shaft 13b. In one embodiment, the distance calculator 94 may be built-in to the controller 40. Alternatively, the controller 40 may have a function of the distance calculator 94. In other words, the controller 40 may also serve as the distance calculator. In these cases, the amplifier 93 directly sends the measured value of intensity of the reflected light to the controller 40, and the distance is calculated in the controller 40.

With such a construction, the distance sensor 80 in this embodiment can measure the movement distance of the movable shaft 13b. The distance calculator 94 is coupled to the controller 40, and the distance calculator 94 transmits the measured value of movement distance of the movable shaft 13b to the controller 40. In one embodiment, the distance sensor 80 may not include the converging lens 85. The sensor head 84 may direct the light to the sensor target 88 without passing through the converging lens 85, and may receive the reflected light from the sensor target 88 without passing through the converging lens 85.

As described above, only the sensor head 84, which is one of components constituting the distance sensor 80, is mounted to the actuator 18. The sensor head 84 has a function to only emit light and receive reflected light, and therefore the sensor head 84 per se is very compact.

Next, the substrate processing apparatus according to still another embodiment will be described. Configurations of this embodiment, which will not be particularly described, are the same as those of the substrate processing apparatus 100 having the notch detection sensor 77 shown in FIG. 2, and redundant descriptions thereof will be omitted.

In this embodiment, the substrate holding device 10 of the substrate processing apparatus 100 has the notch detection sensor 77 shown in FIG. 2, and the distance sensor 80 shown in FIG. 5 or FIG. 10. The distance sensor 80 serves as a sensor to determine whether or not the rollers 11a, 11b of the substrate holding device 10 are holding the wafer W properly.

As described above, the distance sensor 80 is coupled to the controller 40, and the distance sensor 80 sends the measured value of movement distance of the movable shaft 13b (i.e., the measured value of position of the movable shaft 13b) to the controller 40. The controller 40 can compare the measured value of movement distance of the movable shaft 13b (i.e., the position of the movable shaft 13b) with the preset allowable range to thereby determine whether or not the substrate holding device 10 is properly holding the wafer W (i.e., whether or not the substrate holding device 10 has any abnormality). Furthermore, the controller 40 is configured to issue an alarm signal when the measured value of the movement distance described above is out of the allowable range.

When vibration occurs in the movable shaft 13b during rotation of the wafer W, the position of the movable shaft 13b (or the measured value of movement distance of the movable shaft 13b) fluctuates according to the vibration. Therefore, the controller 40 can detect the vibration of the movable shaft 13b based on the fluctuation of the position of the movable shaft 13b (or the fluctuation of the measured value of movement distance of the movable shaft 13b) during the rotation of the wafer W. The controller 40 can detect abnormal rotation of the wafer W based on the vibration of the movable shaft 13b when the substrate holding apparatus 10 holds and rotates the wafer W. Possible causes of the abnormal rotation of the wafer W include wear, deformation, breakage, and dimensional defect of the wafer holding surfaces 31a, 31b of the rollers 11a, 11b, and phase shift of the rotations of the rollers 11a, 11b.

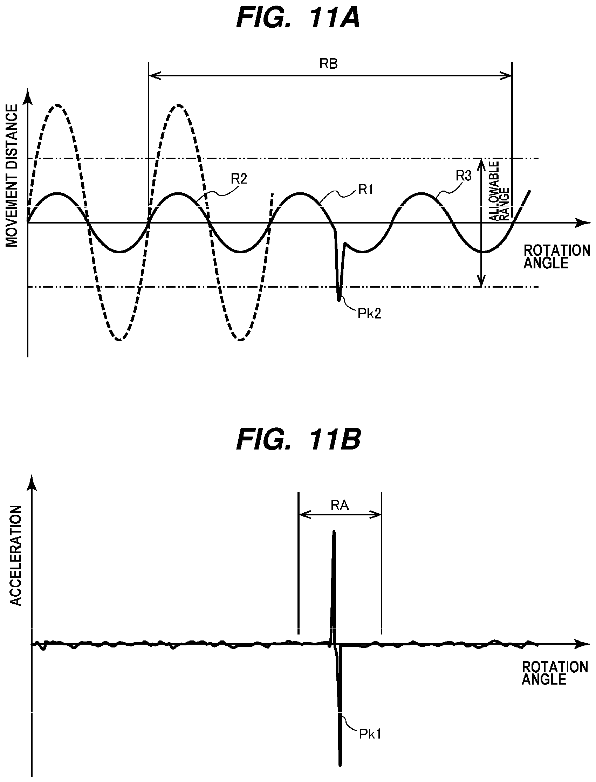

FIG. 11A is a view showing an example of the measured values of the distance sensor, and FIG. 11B is a view showing an example of the measured values of the notch detection sensor 77. In FIG. 11A, a vertical axis represents the position of the movable shaft 13B to which the notch detection sensor 77 is mounted, and a horizontal axis represents an angle of rotation of the roller 11B secured to one end of the movable shaft 13B. In FIG. 11B, a vertical axis represents an acceleration of the movable shaft 13b, to which the notch detection sensor 77 is mounted, in the horizontal direction, and a horizontal axis represents an angle of rotation of the roller 11b secured to one end of the movable shaft 13B.

In FIG. 11A, a value indicating the position of the movable shaft 13b decreases as the movable shaft 13b moves closer to the reference shaft 13a, and increases as the movable shaft 13b moves away from the reference shaft 13a. A position 0 of the movable shaft 13b is defined as a position where the movable shaft 13b is closest to the reference shaft 13a within the movable range of the actuator 18. A rotation angle of 0 degrees of the roller 11b is defined as a predetermined reference angle of the roller 11b. In FIG. 11A, a curve illustrated by a dotted line represents measured values of the distance sensor 80 when an abnormal rotation of the wafer W is occurring. As shown in FIG. 11A, when the abnormal rotation of the wafer W is occurring, the movable shaft 13b vibrates greatly, and the position of the movable shaft 13b fluctuates greatly. At this time, an amplitude of position of the movable shaft 13b is out of a predetermined allowable range. In contrast, when there is no abnormal rotation of the wafer W, the amplitude of position of the movable shaft 13b stays within the predetermined allowable range, as shown by a solid line in FIG. 11A.

The controller 40 compares the amplitude of position of the movable shaft 13b (the measured value of movement distance of the movable shaft 13b) with the predetermined allowable range, and determines that the abnormal rotation of the wafer W has occurred when the amplitude of position of the movable shaft 13b is out of the allowable range. In this specification, the amplitude of position of the movable shaft 13b is defined as a width of the vibration of the movable shaft 13b. In the example shown in FIG. 11A, the amplitude of the movable shaft 13b corresponds to a difference between a maximum value and a minimum value of positions of the movable shaft 13b during one or more rotations of the roller 11b.

As described above, when the notch Nw of the wafer W passes through the movable shaft 13b, the passing waveform Pk2 with a large peak is measured. This pass waveform Pk2 may be out of the allowable range. Since the passing waveform Pk2 is different from the waveform indicating the abnormal rotation of the wafer W, the controller 40 is configured not to issue an alarm when the measured value of the distance sensor 80 is out of the predetermined allowable range and the distance sensor 80 detects the notch Nw.

In this embodiment, the controller 40 utilizes the passing waveform Pk1 in the measured values of the notch detection sensor 77. Specifically, the controller 40 is configured to cancel the alarm, during a predetermined rotation angle (RA) of the roller 11b before and after a time point of detection of the notch Nw from the notch detection sensor 77 (i.e., before and after the passing waveform Pk1), even if the measured value of the distance sensor 80 is out of the predetermined allowable range. The predetermined rotation angle (RA) can be set freely. Such a configuration prevents the passing waveform Pk2, measured when the notch passes the movable shaft 13b, from being determined as the abnormal rotation of the wafer W.

In one embodiment, the notch detection sensor 77 may be omitted. In this case, the distance sensor 80 serves as both a sensor capable of detecting that the notch Nw of the wafer W has passed through the movable shaft 13b, and a sensor for determining whether or not the rollers 11a, 11b of the substrate holding device 10 are holding the wafer W properly.

The controller 40 is configured to cancel the alarm, during the predetermined rotation angle (RB) of the roller 11b before and after the time point of detection of the notch Nw from the distance sensor 80 (i.e., before and after the passing waveform Pk2), even if the measured values of the distance sensor 80 is out of the predetermined allowable range. More specifically, when a peak that is out of the allowable range (hereinafter referred to as a deviation peak) is detected, the controller 40 determines whether or not other peaks that is out of the allowable range are detected in a range of the predetermined rotation angle (RB) before and after the deviation peak. If no other peak that is out of the allowable range is detected in the range of the predetermined rotation angle (RB), the controller 40 determines that the deviation peak is the passing waveform Pk2, and thus does not issue (or cancels) the alarm. If other peak that is out of the allowable range is detected in the range of the predetermined rotation angle (RB), the controller 40 determines that the rotation abnormality of the wafer W is occurring, and thus issues the alarm. The predetermined rotation angle (RB) can be set freely. For example, the predetermined rotation angle (RB) can be set between rotations R2 and R3 before and after the one rotation R1 of the roller that has caused the passing waveform Pk2. Such a configuration prevents the passing waveform Pk2, measured when the notch passes through the movable shaft 13b, from being determined as the abnormal rotation of the wafer W.

The previous description of embodiments is provided to enable a person skilled in the art to make and use the present invention. Moreover, various modifications to these embodiments will be readily apparent to those skilled in the art, and the generic principles and specific examples defined herein may be applied to other embodiments. Therefore, the present invention is not intended to be limited to the embodiments described herein but is to be accorded the widest scope as defined by limitation of the claims.

### Industrial Applicability

The present invention is applicable to a substrate processing method and a substrate processing apparatus for processing a substrate, such as a wafer.

### Reference Signs List

- 1: first surface
- 2: second surface
- 10: substrate holding device
- 11 a, 11b: roller
- 13a,13b: eccentric shaft
- 14a, 14b: first shaft portion
- 15a, 15b: second shaft portion
- 16a, 16b: intermediate shaft portion
- 17a, 17b: counter weight
- 18: actuator
- 19: bearing
- 20: base plate
- 21: movable base
- 23: coupling member
- 24: bearing
- 26: linear motion guide
- 27a,27b: electric motor support member
- 28a,28b: coupling
- 29a,29b: electric motor
- 31a,31b: wafer holding surface (substrate holding surface)
- 40: controller
- 51: piston
- 52a,52b: housing
- 53a,53b: housing body
- 54a,54b: lid
- 55a,55b: separation membrane
- 57a,57b: pressure chamber
- 59a,59b: compressed-gas flow passage
- 62a,62b: pressure regulator
- 63a,63b: switching valve
- 64: compressed-gas supply source
- 71a,71b: central portion
- 72a,72b: inner wall portion
- 73a,73b: folded-back portion
- 74a,74b: outer wall portion
- 75a,75b: thick portion
- 77: notch detection sensor
- 80: distance sensor
- 81: magnet
- 84: sensor head
- 85: converging lens
- 88: sensor target
- 92A: light-emitting optical fiber cable
- 92B: light-receiving optical fiber cable
- 93: amplifier
- 93a: light source
- 93b: light-intensity measuring device
- 94: distance calculator
- 100: substrate processing apparatus
- 200: processing head
- 201: processing tool

## Claims

1. A substrate processing method, comprising:
contacting a periphery of a substrate having a notch with three or more rollers each secured to three or more eccentric shafts including at least one reference shaft and at least one movable shaft which can be moved in a direction closer to and away from the reference shaft, each of the eccentric shafts having a first shaft portion coupled to electric motor, and a second shaft portion which is eccentric from the first shaft portion and to which the rollers are secured;
rotating the first shaft portions of the three or more eccentric shafts about their respective own axes, and further causes the three or more rollers to make a circular motion, thereby rotating the substrate about its axis and causing the substrate to make a circular motion;
contacting a processing tool with the rotating and circularly moving substrate to thereby process the substrate;
calculating a rotational speed of the substrate, during processing of the substrate, based on measured values of a notch detection sensor for detecting that a notch has passed through the movable shaft; and
issuing an alarm when the calculated rotational speed of the substrate is out of an allowable range which is set with respect to a theoretical rotational speed of the substrate.

2. The substrate processing method according to claim 1, further comprising: performing an additional processing to the substrate based on a difference or a ratio between the rotational speed of the substrate and the theoretical rotational speed when the calculated rotational speed of the substrate falls below a lower limit of the allowable range.

3. The substrate processing method according to claim 1 or 2, wherein the notch detection sensor is an acceleration sensor configured to measure acceleration generated when the movable shaft moves closer to and away from the reference shaft.

4. The substrate processing method according to claim 1 or 2, wherein the notch detection sensor is a distance sensor configured to measure a movement distance of the movable shaft when the movable shaft moves closer to and away from the reference shaft.

5. A substrate processing method, comprising:
contacting a periphery of a substrate having a notch with three or more rollers each secured to three or more eccentric shafts including at least one reference shaft and at least one movable shaft which can be moved in a direction closer to and away from the reference shaft, each of the eccentric shafts having a first shaft portion coupled to electric motors, and a second shaft portion which is eccentric from the first shaft portion and to which the rollers are secured;
rotating the first shaft portions of the three or more eccentric shafts about their respective own axes, and further causes the three or more rollers to make a circular motion, thereby rotating the substrate about its axis and causing the substrate to make a circular motion;
contacting a processing tool with the rotating and circularly moving substrate to thereby process the substrate;
measuring, during processing of the substrate, a movement distance of the movable shaft by use of a distance sensor, and further detecting that a notch has passed through the movable shaft, by use of a notch detection sensor;
issuing an alarm when measured value of the distance sensor is out of a predetermined allowable range, and the notch detection sensor is not detecting the notch; and
not issuing an alarm when the measured value of the distance sensor is out of the predetermined allowable range, and the notch detection sensor is detecting the notch.

6. The substrate processing method according to claim 5, wherein, during a predetermined rotation angle of the roller before and after a time point of detection of the notch by the notch detection sensor, the alarm is canceled even if the measured value of the distance sensor is out of the predetermined allowable range.

7. A substrate processing method, comprising:
contacting a periphery of a substrate having a notch with three or more rollers each secured to three or more eccentric shafts including at least one reference shaft and at least one movable shaft which can be moved in a direction closer to and away from the reference shaft, each of the eccentric shafts having a first shaft portion coupled to electric motors, and a second shaft portion which is eccentric from the first shaft portion and to which the rollers are secured;
rotating the first shaft portions of the three or more eccentric shafts about their respective own axes, and further causes the three or more rollers to make a circular motion, thereby rotating the substrate about its axis and causing the substrate to make a circular motion;
contacting a processing tool with the rotating and circularly moving substrate to thereby process the substrate;
measuring, during processing of the substrate, a movement distance of the movable shaft by use of a distance sensor, and further detecting that a notch has passed through the movable shaft, by use of the distance sensor;
issuing an alarm when measured value of the distance sensor is out of a predetermined allowable range, and the distance sensor is not detecting the notch; and
not issuing an alarm when the measured value of the distance sensor is out of the predetermined allowable range, and the distance sensor is detecting the notch.

8. The substrate processing method according to claim 7, wherein, during a predetermined rotation angle of the roller before and after a time point of detection of the notch by the distance sensor, the alarm is canceled even if the measured value of the distance sensor is out of the predetermined allowable range.

9. A substrate processing apparatus, comprising:
three or more eccentric shafts including at least one reference shaft and at least one movable shaft, each of the eccentric shafts having a first shaft portion, and a second shaft portion which is eccentric from the first shaft portion;
three or more rollers each secured to the second shaft portion of each of the three or more eccentric shafts, and capable of contacting a periphery of a substrate having a notch;
three or more electric motors for rotating the first shaft portions of the three or more eccentric shafts about their respective own axes, and further causes the three or more rollers to make a circular motion, thereby rotating the substrate about its axis and causing the substrate to make a circular motion;
an actuator configured to move the at least one movable shaft in a direction closer to and away from the reference shaft;
a processing tool configured to contact a surface of the rotating and circularly moving substrate to thereby process the surface of the substrate;
a notch detection sensor configured to detect that the notch has passed through the movable shaft; and
a controller to which the notch detection sensor is coupled,
wherein the controller is configured:
to calculate a rotational speed of the substrate, during processing of the substrate, based on measured values of the notch detection sensor; and
to issue an alarm when the calculated rotational speed of the substrate is out of an allowable range which is set with respect to a theoretical rotational speed of the substrate.

10. The substrate processing apparatus according to claim 9, wherein the controller is configured to perform an additional processing to the substrate based on a difference or a ratio between the rotational speed of the substrate and the theoretical rotational speed when the calculated rotational speed of the substrate falls below a lower limit of the allowable range.

11. The substrate processing apparatus according to claim 9 or 10, wherein the notch detection sensor is an acceleration sensor configured to measure acceleration generated when the movable shaft moves closer to and away from the reference shaft.

12. The substrate processing apparatus according to claim 9 or 10, wherein the notch detection sensor is a distance sensor configured to measure a movement distance of the movable shaft when the movable shaft moves closer to and away from the reference shaft.

13. A substrate processing apparatus, comprising:
three or more eccentric shafts including at least one reference shaft and at least one movable shaft, each of the eccentric shafts having a first shaft portion, and a second shaft portion which is eccentric from the first shaft portion;
three or more rollers each secured to the second shaft portion of each of the three or more eccentric shafts, and capable of contacting a periphery of a substrate having a notch;
three or more electric motors for rotating the first shaft portions of the three or more eccentric shafts about their respective own axes, and further causes the three or more rollers to make a circular motion, thereby rotating the substrate about its axis and causing the substrate to make a circular motion;
an actuator configured to move the at least one movable shaft in a direction closer to and away from the reference shaft;
a processing tool configured to contact a surface of the rotating and circularly moving substrate to thereby process the surface of the substrate;
a notch detection sensor configured to detect that the notch has passed through the movable shaft;
a distance sensor configured to measure a movement distance of the movable shaft when the movable shaft moves closer to and away from the reference shaft; and
a controller to which the notch detection sensor and the distance sensor is coupled,
wherein the controller is configured:
to issue an alarm when measured value of the distance sensor is out of a predetermined allowable range, and the notch detection sensor is not detecting the notch; and
not to issue an alarm when the measured value of the distance sensor is out of the predetermined allowable range, and the notch detection sensor is detecting the notch.

14. The substrate processing apparatus according to claim 13, wherein the controller is configured to cancel the alarm, during a predetermined rotation angle of the roller before and after a time point of detection of the notch by the notch detection sensor, even if the measured value of the distance sensor is out of the predetermined allowable range.

15. A substrate processing apparatus, comprising:
three or more eccentric shafts including at least one reference shaft and at least one movable shaft, each of the eccentric shafts having a first shaft portion, and a second shaft portion which is eccentric from the first shaft portion;
three or more rollers each secured to the second shaft portion of each of the three or more eccentric shafts, and capable of contacting a periphery of a substrate having a notch;
three or more electric motors for rotating the first shaft portions of the three or more eccentric shafts about their respective own axes, and further causes the three or more rollers to make a circular motion, thereby rotating the substrate about its axis and causing the substrate to make a circular motion;
an actuator configured to move the at least one movable shaft in a direction closer to and away from the reference shaft;
a processing tool configured to contact a surface of the rotating and circularly moving substrate to thereby process the surface of the substrate;
a distance sensor configured to measure a movement distance of the movable shaft when the movable shaft moves closer to and away from the reference shaft, and further to be able to detect that the notch has passed through the movable shaft; and
a controller to which the notch detection sensor and the distance sensor is coupled,
wherein the controller is configured:
to issue an alarm when measured value of the distance sensor is out of a predetermined allowable range, and the distance sensor is not detecting the notch; and
not to issue an alarm when the measured value of the distance sensor is out of the predetermined allowable range, and the distance sensor is detecting the notch.

16. The substrate processing apparatus according to claim 15, wherein the controller is configured to cancel the alarm, during a predetermined rotation angle of the roller before and after a time point of detection of the notch by the distance sensor, even if the measured value of the distance sensor is out of the predetermined allowable range.
